# EUROPEAN PATENT APPLICATION

(11) **EP 1 006 658 A1**
(43) Date of publication of application: **07.06.2000**
(21) Application number: 98830727.8
(22) Date of filing: 03.12.1998
(51) Int. Cl.: H03K 19/0175

(54) **Low dissipation biCMOS ECL/CMOS interface**

(71) Applicant: STMicroelectronics S.r.l., 20041 Agrate Brianza (Milano) (IT)
(72) Inventor: Ottini, Daniele, 27100 Pavia (IT); Bruccoleri, Melchiorre, 20017 Rho (IT); Marchese, Stefano, 27100 Pavia (IT); Bollati, Giacomino, 29015 Castel San Giovanni (IT)
(74) Representative: Pellegri, Alberto

(57) **Abstract**

A BiCMOS ECL/CMOS interface circuit for converting a high frequency pseudo-ECL signal with a voltage swing in the order of few hundreds of millivolts into a CMOS signal with a voltage swing substantially equal to the supply voltage, comprising a differential input stage composed of a pair of NPN bipolar junction transistors (Q1, Q2) in a common emitter configuration, a bias current generator (IBIAS) functionally coupled between the common emitter node of said NPN transistors and ground and means driven by a respective transistor of said input pair (Q1, Q2) driving the control node of a respective output CMOS stage (M5-M7, M6-M8), is provided with first and second common-collector stages each constituted by an NPN bipolar junction transistor(Q3, Q4) and driven by a respective transistor of said pair of NPN transistors (Q1, Q2); and with a pair of identical PMOS transistors (M1, M2) with gates connected in common to a bias voltage (POL), each PMOS transistor (M1, M2) having a source coupled to the emitter of a respective transistor (Q3, Q4) of said common-collector stages and a drain connected to a load current generator (I) and to said control node of a respective output CMOS stage (M5-M7, M6-M8), for reducing current absorption without impairing performance.

## Description

### FIELD OF THE INVENTION

The present invention relates to processing systems of high frequency digital signals and more in particular to a converter of differential logic signals of a limited swing in full-swing CMOS signals.

### BACKGROUND OF THE INVENTION

In many high frequency applications, as for example in read channels of mass memory devices, for example of hard disk drives (HDD), the high frequency of operation imposes, at least in the amplifying, conversion, and equalisation stages, the use of bipolar junction devices and, at least in the analog-to-digital conversion stages, the use of high speed ECL circuits.

Downstream of the stages of analog-to-digital conversion and pre-processing of the logic signals it is necessary to convert differential logic signals (Pseudo ECL) having a limited voltage swing, commonly in the order of few hundreds of millivolts, into full-swing CMOS signals, that is with a voltage swing substantially equal to the supply voltage.

The generation of full-swing signals may be implemented efficiently only by using complementary devices. However, as well known to a person expert in the art, the most practiced mixed technologies of fabrication (BiCMOS) do not normally provide PNP signal transistors and on the other hand, p-channel MOS devices are much slower than n-channel MOS devices.

If the pseudo ECL signal to be converted into a CMOS signal has a particularly limited voltage swing, for instance, in the order of a hundred millivolts, as it is often the case in high frequency systems, the input stage (transistor) is almost invariably an n-channel or bipolar junction NPN, and the limit to speed is typically represented by the minor circuit necessarily realised with PMOS devices, through which a CMOS output stage is normally driven.

An analysis of digital BiCMOS circuits is reported in the article: "Analysis and optimisation of BiCMOS digital circuits structures", by S.H. Embabi, A. Bellaouar, and M. I. Elmasry, IEEE Journal of solid-state circuits, Vol. 26, No. 4, April 1991.

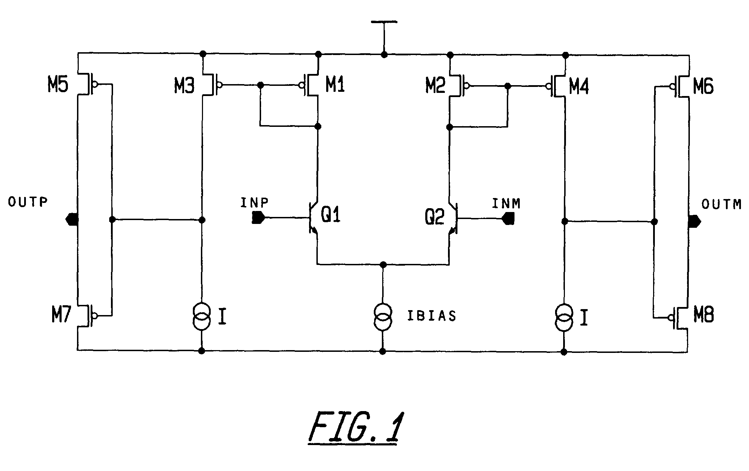

Figure 1 shows q typical BiCMOS ELC/CMOS interfacing circuit realized according to the known technique.

The input stage is a differential stage composed of a pair of bipolar junction NPN transistors Q1 and Q2 in common-emitter configuration and biased by a current generator IBIAS normally coupled between the common emitter node of the pair of input transistors and ground.

The driving of the two output CMOS stages, M5-M7 and M6-M8, is done through a PMOS current mirror, composed of the M1-N32 and M2-M4 transistors, respectively, and respective load current generators I1 and I2.

To compensate, for the intrinsic lower speed of PMOS devices, in high frequency applications, the PMOS devices must be adequately dimensioned and this implies a corresponding increment of current absorption.

### OBJECT AND SUMMARY OF THE INVENTION

The aim of the present invention is to provide an ELC/CMOS interface converter circuit which, for the same speed performance has a reduced power consumption compared to known converter circuits.

This result is obtained according to the present invention by driving the CMOS output stage instead of through a PMOS current mirror, through a common-collector stage constituted by an NPN bipolar junction transistor driven by the respective transistor of the differential input pair and by a PMOS transistor in common-gate configuration whose load is represented by a bias current generator and by the capacitance associated to the control node of the output CMOS stage.

In this way, the PMOS device is driven through an NPN stage so that its gate capacitance is driven by a device (the NPN transistor) characterised by a very high band-gain product. Moreover, the current delivered by the PMOS device is fixed by a dedicated bias circuit and thereby the PMOS transistor may be dimensioned freely such to ensure the desired performance in terms of switching speed without any penalization in terms of a correspondent increment of the current absorption.

### BRIEF DESCRIPTION OF THE DRAWINGS

**Figure 1** shows, as already mentioned above, a typical ECL/CMOS interface converter circuit.
**Figure 2** shows the ECL/CMOS interface converter circuit of the invention.
**Figure 3** is a possible form of realization of a bias circuit for the converter of the invention shown in figure 2.

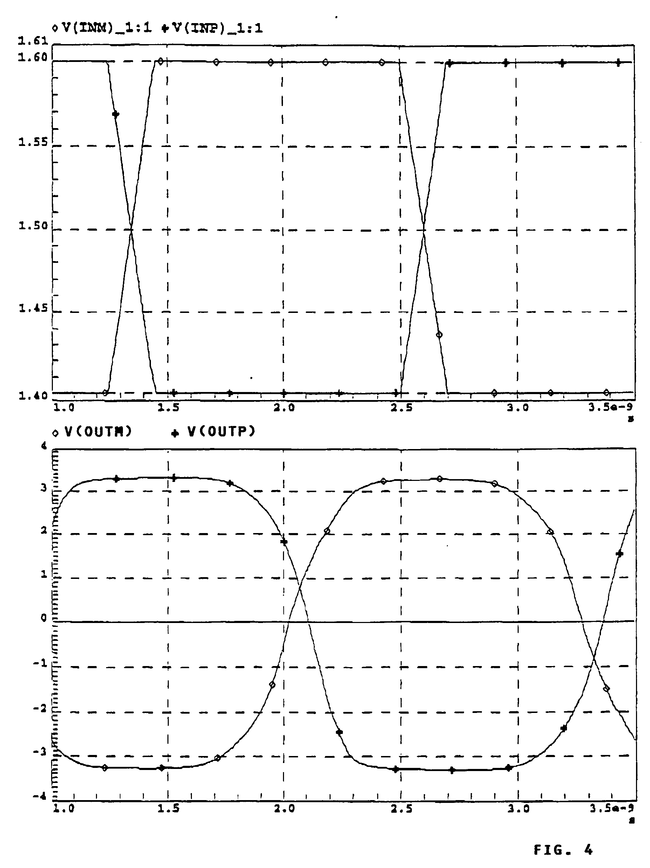

**Figure 4** shows the waveforms of the ECL input signals and of the corresponding CMOS output signals produced by the known circuit of Figure 1 and by the circuit of the invention of figure 2.

### DESCRIPTION OF AN EMBODIMENT OF THE INVENTION

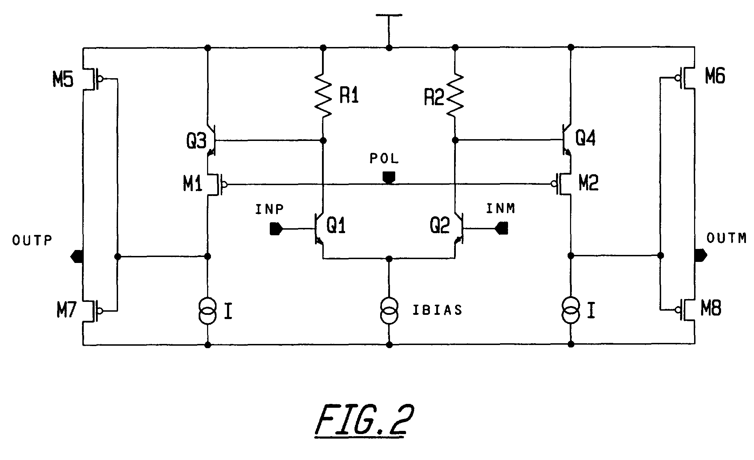

By referring to figure 2, the BiCMOS ELC/CMOS interface converter circuit of the invention comprises as the known circuits, an input differential stage composed by the pair of NPN transistors, Q1 and Q2, by the current generator IBIAS and by the two load resistors, R1 and R2.

Differently from the known circuit of figure 1, the two output CMOS stages, M5-M7 and M6-M8, respectively, are driven, rather than through PMOS mirrors, through common-collector stages, Q3 and Q4, respectively, and respective PMOS transistors M1 and M2, in common gate configuration, having a source coupled to the emitter of the relative NPN transistor and a drain coupled to a bias current generator I and to the control node of the respective output CMOS stage.

The gate capacitance of the PMOS transistor is driven by the NPN transistor which represents a stage with a very high gain-band product and therefore the size of the PMOS transistor may be suitably increased without problems.

On the other side, the current that may be delivered by the PMOS is established by the bias circuit, thus avoiding the drawback of an increased power consumption.

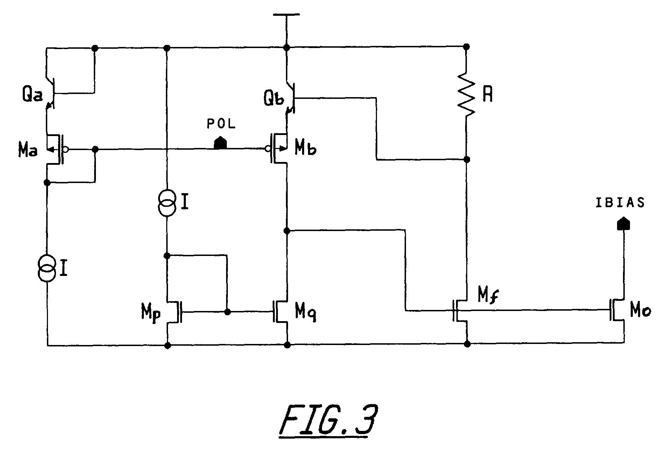

A possible form of realization of a suitable biasing circuit capable of generating the bias current IBIAS and a gate biasing voltage for the pair of PMOS transistors M1 and M2 in common-gate configuration, is shown in Figure 3.

The circuit simulates the functional circuit of figure 2 for a condition of full unbalance, such to ensure the delivery of a bias current IBIAS on the common emitter node of the input differential stage, Q1 and Q2, sufficient to ensure a correct dynamic of the input stage and thus guarantee the output of a driving current for the respective common-collector NPN stage. This ensures the delivery by the respective PMOS of a pre-established current, sufficient to ensure a correct output swing.

The bias circuit of figure 3 supplies also the common gate biasing voltage POL for the M1 and M2 transistors such to ensure a correct current swing under any functioning condition.

Of course, both the bias current IBIAS and the bias voltage POL of the common gate node POL may also be generated and/or furnished to the converter circuit of the invention in any suitable manner other than by way of the bias circuit of figure 3, as long as the above mentioned requisites are met.

## Claims

1. A BiCMOS ECL/CMOS interface circuit for converting a high frequency pseudo ECL signal with a voltage swing in the order of few hundreds of millivolts into a CMOS signal with a voltage swing substantially equal to the supply voltage, comprising a differential input stage composed of a pair of NPN bipolar junction transistors (Q1, Q2) in a common emitter configuration, a bias current generator (IBIAS) functionally coupled between the common emitter node of said NPN transistors and ground and means driven by a respective transistor of said input pair (Q1, Q2) driving the control node of a respective output CMOS stage (M5-M7, M6-M8), characterised in that said means consist of:
first and second common-collector stages each constituted by an NPN bipolar junction transistor(Q3, Q4) and driven by a respective transistor of said pair of NPN transistors (Q1, Q2);
a pair of identical PMOS transistors (M1, M2) with gates connected in common to a bias voltage (POL), each PMOS transistor (M1, M2) having a source coupled to the emitter of a respective transistor (Q3, Q4) of said common-collector stages and a drain connected to a load current generator (I) and to said control node of a respective output CMOS stage (M5-M7, M6-M8).

2. The circuit according to claim 1, characterized in that said bias current generator (IBIAS) is a circuit reproducing the BiCMOS ECL/CMOS interface converter of claim 1 in a condition of full unbalance and outputting a bias current (IBIAS)such to ensure a correct dynamic of the input differential stage (Q1, Q2) thus ensuring a driving current of said common-collector stages sufficient to deliver, through said common-gate PMOS transistor a pre-established maximum current.
